# EUROPEAN PATENT APPLICATION

(11) **EP 3 223 425 A1**
(43) Date of publication of application: **27.09.2017**
(21) Application number: 16177034.2
(22) Date of filing: 30.06.2016
(51) Int. Cl.: H02S 40/34

(54) **SOLAR POWER SYSTEM AND METHOD FOR MANUFACTURING THE SAME**

(30) Priority: 24.03.2016 TW 105204163
(71) Applicant: Eterbright Solar Corporation, Toufen City, Miaoli County (TW)
(72) Inventor: HUANG, TING-HUI, 35154 Miaoli County (TW)
(74) Representative: Becker Kurig Straus

(57) **Abstract**

A solar power system (100, 100') and a method for manufacturing the same are provided. The solar power system (100, 100') includes at least one solar power module (110) and a bypass diode module (120). The at least one solar power module (110) comprises a plurality of solar panels (112) connected in parallel. The bypass diode module (120) has a plurality of bypass diodes (122) connected in series. The at least one solar power module (110) and the bypass diode module (120) are connected in parallel.

## Description

### FIELD OF THE INVENTION

The invention relates to a power system and a method for manufacturing the same, and more particularly relates to a solar power system and a method for manufacturing the same.

### BACKGROUND OF THE INVENTION

With the rapid development of industry, fossil fuels are progressively exhausted and the question of the greenhouse effect is concerned by the global. Steady supply of a source of energy has been a major global issue. In contrast to coal, natural gas or nuclear power, a solar power system is a renewable resource. The solar power system converts solar energy into electrical energy through a photoelectric effect. Therefore, the photoelectric effect does not generate carbon dioxide, nitrogen oxides, sulfur oxides and polluting gases. In addition, the solar power system could reduce our dependence on fossil fuels and provide a safe source of energy.

A solar power system used nowadays consists of a plurality of solar power modules connected in series in order to output a greater voltage and current. However, when the solar power system is subject to non-uniform light, the solar power system would suffer severely.

Specifically, in the solar power system, because the solar power module must be disposed outdoors, the solar power module would be affected by the environment. As a result, the solar power module is easy to fail. (e.g., fails due to partial shading fault). The partial shading fault means that a module of the solar power module or parts of the batteries of the solar power module is subject to non-uniform light. The module and the parts of the batteries receive a reverse current due to partial shading fault, so the module and the parts of the batteries get damaged. Therefore, the service life of the solar power system would be reduced. As a result, improving today's solar power system is imperative.

### SUMMARY OF THE INVENTION

One object of the present invention is to provide a solar power system. The solar power system could reduce the incidence of failure and has a long service life.

A solar power system is provided. The solar power system comprises at least one solar power module and a bypass diode module. The at least one solar power module comprises a plurality of solar panels connected with each other in parallel. The bypass diode module comprises a plurality of bypass diodes connected with each other in series. The at least one solar power module and the bypass diode module are connected in parallel.

In the above solar power system, the solar panels are thin-film solar panels.

In the above solar power system, the thin-film solar panels comprise a-Si solar cells, µc-Si soalr cells, CdS solar cells, CdTe solar cells, CIS solar cells, CIGS solar cells, dye-sensitized solar cells, or polymer solar cells.

In the above solar power system, the at least one solar power module comprises a plurality of solar power modules.

In the above solar power system, the plurality of solar power modules are connected with each other in series.

In the above solar power system, the plurality of solar power modules are connected with each other in parallel.

Another object of the present invention is to provide a method for manufacturing a solar power system. The method for manufacturing the solar power system could reduce the failure probability and have long service life.

A method for manufacturing a solar power system is provided. The method for manufacturing the solar power system comprising the steps of: providing a plurality of solar panels; connecting these solar panels in parallel in order to assemble at least one solar power module; providing a plurality of bypass diodes; connecting these bypass diodes in series in order to assemble a bypass diode module; and connecting the at least one solar power module and the bypass diode module in parallel.

In the above method for manufacturing a solar power system, the plurality of solar panels are thin-film solar panels.

In the above method for manufacturing a solar power system, the thin-film solar panel comprises a-Si solar cells, µc-Si soalr cells, CdS solar cells, CdTe solar cells, CIS solar cells, CIGS solar cells, dye-sensitized solar cells, or polymer solar cells.

In the above method for manufacturing a solar power system, the at least one solar power module comprises a plurality of solar power modules.

In the above method for manufacturing a solar power system, the plurality of solar power modules are connected with each other in series.

In the above method for manufacturing a solar power system, the plurality of solar power modules are connected with each other in parallel.

In summary, the present invention is to connect the solar power module and the bypass diode module in parallel in order to prevent the parts of the solar panels from receiving reverse current (hence being damaged). Furthermore, in the present invention, the bypass diode module consists of a plurality of bypass diodes connected with each other in series. Thus, when these bypass diodes start acting, these bypass diodes could equalize heat to reduce the incidence of failure. In addition, when one of the bypass diodes collapses due to overheating or breakdown, the solar power system would not get damaged as a result of this malfunctioned bypass diode. As a result, the solar power system of the present invention would be protected, so the solar power system has a long service life.

### BRIEF DESCRIPTION OF THE DRAWINGS

Fig.1 illustrates a schematic diagram of a solar power system in accordance with an embodiment of the present invention;
Fig.2 illustrates a flow diagram of manufacturing the solar power system in accordance of Fig.1; and
Fig.3 illustrates a schematic diagram of the solar power system in accordance with another embodiment of the present invention.

### DETAILED DESCRIPTION OF PREFERRED EMBODIMENTS

The foregoing, as well as additional objects, features and advantages of the invention would be more readily apparent from the following detailed description, which proceeds with reference to the accompanying drawings.

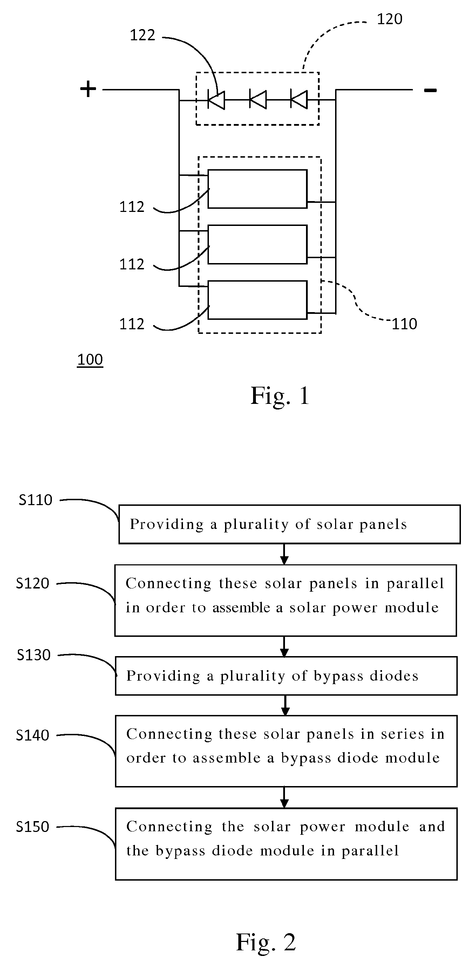

Fig.1 illustrates a schematic diagram of a solar power system in accordance with an embodiment of the present invention. Please refer to Fig.1. The solar power system 100 comprises at least one solar power module 110 and a bypass diode module 120. The solar power module 110 includes a plurality of solar panels 112. The bypass diode module 120 includes a plurality of bypass diodes 122.

It is worth mentioning that these solar panels 112 of the solar power module 110 are connected with each other in parallel. In addition, these bypass diodes 122 of the bypass diode module 120 are connected with each other in series. The solar power module 110 and the bypass diode module 120 are connected in parallel.

Furthermore, these solar panels 112 of the solar power module 110 are connected with each other in parallel in order to enhance power wattage and operating stability of the solar power system 100. Moreover, the solar power module 110 is also connected to these bypass diodes 122 of the bypass diode module 120 in parallel. Therefore, when parts of the solar panels 112 of the solar power module 110 are in a state of the partial shading fault, the bypass diode module 120 connected to the solar power module 110 in parallel would be conducted to prevent the parts of the solar panels 112 from receiving reverse current (the reverse current would damage the solar panels 112). Therefore, the bypass diode module 120 functions to protect the solar power system 100.

Furthermore, because the bypass diode module 120 includes a plurality of bypass diodes 122, when one of the bypass diodes 122 collapses due to overheating or breakdown, the others still work. As a result, even if one of the bypass diodes 122 receives reverse current and generates heat, the solar power system 100 does not get damaged.

Specifically, the solar power system 100 of the present invention is to use a design of a plurality of bypass diodes 122 to equalize heat and prevent the solar system 100 from receiving reverse current. In addition, even though one of the bypass diodes 122 is malfunctioned, it still is a conductor, so it could be used for electrical connection. The rest of the bypass diodes 122 (functional bypass diodes 122) could equalize heat and prevent the reverse current. In other words, the solar power system 100 of the present invention would be protected, so the solar power system 100 has a long service life.

In the Fig.1, the solar power module 110 includes three solar panels 112as an example. However, the solar power module 110 could include more solar panels 112 (e.g., four solar panels, five solar panels, or six solar panels) or include less solar panels 112 (e.g., two solar panels). Similarly, the bypass diode module 120 includes three bypass diodes 122 as an example in the Fig.1. However, the bypass diode module 120 could include more bypass diodes 122 (e.g., four bypass diodes, five bypass diodes, or six bypass diodes) or include less bypass diodes 122 (e.g., two bypass diodes).

In the present invention, the solar panel is for exmaple a thin-film solar panel. For example, the thin-film solar panel comprises a-Si solar cells, µc-Si soalr cells, CdS solar cells, CdTe solar cells, CIS solar cells, CIGS solar cells, dye-sensitized solar cells, or polymer solar cells.

Fig.2 illustrates a flow diagram of manufacturing the solar power system in accordance of Fig.1. Please refer to Fig.2. A method for manufacturing a solar power system comprising the steps of: first, as described in step S110, providing a plurality of solar panels; next, as described in step S120, connecting these solar panels in parallel in order to assemble a solar power module; next, as described in step S130, providing a plurality of bypass diodes; next, as described in step S140, connecting these bypass diodes in series in order to assemble a bypass diode module; next, as described in step S150, connecting the solar power module and the bypass diode module in parallel.

In the Fig.2, the solar power module is completed earlier than the bypass diode module. However, the bypass diode module could alternatively be completed earlier than the solar power module. And then, the bypass diode module is connected to the solar power module in parallel.

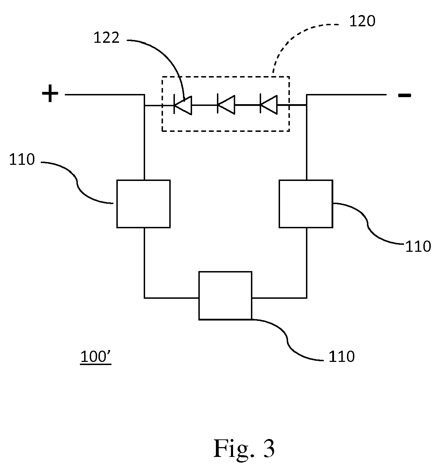

Fig.3 illustrates a schematic diagram of the solar power system 100' in accordance with another embodiment of the present invention. Please refer to Fig.3. The solar power system 100' is similar to the solar power system 100. The difference the two modules is that the solar power system 100' further comprises a plurality of solar power modules 110, and the multiple solar power modules 110 are connected with each other in series. Thus, the solar power system 100' could output a greater voltage and current. In the Fig.3, the solar power system 100' comprises three solar power modules 110 as an example. However, the solar power system 100' could include more solar power module110 (e.g., four solar power modules, five solar power modules, or six solar power modules) or less solar power module 110 (e.g., two solar power modules).

In summary, the present invention is to connect the solar power module and the bypass diode module 120 in parallel in order to prevent the parts of the solar panels from receiving reverse current (the reverse current would damage the solar panels). Furthermore, in the present invention, the bypass diode module consists of a plurality of bypass diodes connected with each other in series. Thus, when these bypass diodes start acting, a plurality of bypass diodes could equalize heat to reduce the incidence of failure. In addition, when one of the bypass diodes collapses due to overheating or breakdown, the solar power system would not get damaged due to this malfunctioned bypass diode. As a result, the solar power system of the present invention would be protected, so the solar power system has a long service life.

Although the description above contains many specifics, these are merely provided to illustrate the invention and should not be construed as limitations of the invention's scope. Thus it will be apparent to those skilled in the art that various modifications and variations can be made in the system and processes of the present invention without departing from the spirit or scope of the invention.

## Claims

1. A solar power system (100, 100') comprising:
at least one solar power module (110) comprising a plurality of solar panels (112) connected with each other in parallel; and
a bypass diode module (120) comprising a plurality of bypass diodes (122) connected with each other in series;
wherein the at least one solar power module (110) and the bypass diode module (120) are connected in parallel.

2. The solar power system according to claim 1, wherein the at least one solar power module (110) comprises a plurality of solar power modules.

3. The solar power system according to claim 2, wherein the plurality of solar power modules are connected with each other in series.

4. The solar power system according to claim 2, wherein the plurality of solar power modules are connected with each other in parallel.

5. The solar power system according to any one of claims 1-4, wherein the plurality of solar panels (122) are thin-film solar panels.

6. The solar power system according to claim 5, wherein the thin-film solar panels comprise a-Si solar cells, µc-Si soalr cells, CdS solar cells, CdTe solar cells, CIS solar cells, CIGS solar cells, dye-sensitized solar cells, or polymer solar cells.

7. A method for manufacturing a solar power system (100) comprising:
(S110) providing a plurality of solar panels (112);
(S120) connecting these solar panels (112) in parallel in order to assemble at least one solar power module (110);
(S130) providing a plurality of bypass diodes (122);
(S140) connecting these bypass diodes (122) in series in order to assemble a bypass diode module (120); and
(S150) connecting the at least one solar power module (110) and the bypass diode module (120) in parallel.

8. The method for manufacturing the solar power system according to claim 7, wherein the at least one solar power module (110) comprises a plurality of solar power modules.

9. The method for manufacturing the solar power system according to claim 8, wherein the plurality of solar power modules are connected with each other in series.

10. The method for manufacturing the solar power system according to claim 8, wherein the plurality of solar power modules are connected with each other in parallel.

11. The method for manufacturing the solar power system according to any one of claims 7-10, wherein the plurality of solar panels (112) are thin-film solar panels.

12. The method for manufacturing the solar power system according to claim 11, wherein the thin-film solar panels comprises a-Si solar cells, µc-Si soalr cells, CdS solar cells, CdTe solar cells, CIS solar cells, CIGS solar cells, dye-sensitized solar cells, or polymer solar cells.
